# EUROPEAN PATENT APPLICATION

(11) **EP 4 124 910 A1**
(43) Date of publication of application: **01.02.2023**
(21) Application number: 21188452.3
(22) Date of filing: 29.07.2021
(51) Int. Cl.: G03F 7/20, G02B 26/08

(54) **PROGRAMMABLE ILLUMINATOR OF A LITHOGRAPHIC APPARATUS**

(71) Applicant: ASML Netherlands B.V., 5500 AH Veldhoven (NL)
(72) Inventor: STEEGHS, Marco, Matheus, Louis, 5500 AH Veldhoven (NL); HARTGERS, Albertus, 5500 AH Veldhoven (NL); PASVEER, Willem, Franke, 5500 AH Veldhoven (NL)
(74) Representative: ASML Netherlands B.V.

(57) **Abstract**

The invention relates to a system comprising a micromirror array including:
- a substrate,
- a plurality of moveable micromirrors for reflecting incident light and supported from the substrate,
- an actuator system configured to position each of the plurality of micromirrors based on one or more actuator control signals,
- a measurement system configured to measure a position of each of the plurality of micromirrors, and
- a control unit configured to generate the one or more actuator control signals based on an output of the measurement system.

At least some of the micromirrors of the array comprise a temperature sensor configured to measure a temperature of the respective micromirror. The system further includes a processor, wherein the processor is configured to receive the measured temperatures of the at least some micromirrors and to determine an incident light related energy parameter.

## Description

### FIELD

The present invention relates to a micromirror array, a programmable illuminator comprising such a micromirror array, a lithographic apparatus comprising such a micromirror array or programmable illuminator, an inspection and/or metrology apparatus comprising such a programmable illuminator, a method for determining an incident light related energy parameter, and a device manufacturing method for manufacturing a device with a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV radiation for use by a lithographic apparatus is generated by a source which may for example be a laser produced plasma (LPP) source. The amount of power output from the EUV radiation source will vary over time. If the power of EUV radiation output from the EUV radiation source is too high then this may cause damage to components of the lithographic apparatus. If the power of the EUV radiation is too small then this will reduce the number of substrates exposed by the lithographic apparatus per hour (which may be referred to as throughput). It is therefore desirable to be able to measure the power of EUV radiation, since this measurement allows the EUV radiation source to be adjusted accordingly.

It is known to use a mirror array to condition the radiation beam, wherein at least some of the mirrors comprise a reflective surface and an arm which extends from a surface opposite to the reflective surface, wherein the mirror array further comprises a support structure provided with a plurality of sensing apparatuses, the sensing apparatuses being configured to measure gaps between the sensing apparatuses and the arms which extend from the mirrors.

Disadvantages associated with the gap measurements relate to the indirect measurement principle to determine a temperature of the macro facet mirrors which is strongly dependent on the orientation of the mirror and needs repeated zeroing due to production tolerances and thermal history. Another disadvantage relates to the relatively long time constants of the components making it difficult to predict cold an warm states of the mirror. Further, a mirror and thus each sensing apparatus represents a relatively large portion of the radiation beam. All in all, the temporal and spatial resolution is limited and special attention needs to be paid to find useable data points. Hence, preferably at regular intervals, e.g. once per day, the radiation beam is directed towards a dedicated energy sensor to monitor the power of the radiation source. However, correlation between the sensing apparatus and the energy sensor is poor.

### SUMMARY

Considering the above, it is an object of the invention to provide a system comprising:
- a micromirror array comprising:
   ∘ a substrate,
   ∘ a plurality of moveable micromirrors for reflecting incident light and supported from the substrate,
   ∘ an actuator system configured to position each of the plurality of micromirrors based on one or more actuator control signals,
   ∘ a measurement system configured to measure a position of each of the plurality of micromirrors,
   ∘ a control unit configured to generate the one or more actuator control signals based on an output of the measurement system,
- a processor,

wherein at least some of the micromirrors of the array comprise a temperature sensor configured to measure a temperature of the respective micromirror,
and wherein the processor is configured to receive the measured temperatures of the at least some micromirrors and to determine an incident light related energy parameter.

According to an embodiment of the invention, there is provided a programmable illuminator comprising a system according to the invention for conditioning a radiation beam.

According to another embodiment of the invention, there is provided a lithographic apparatus comprising:
- an illumination system configured to condition a radiation beam,
- a support structure constructed to support a patterning device, the patterning device being capable of imparting the radiation beam with a pattern in its cross-section to form a patterned radiation beam,
- a substrate table constructed to hold a substrate, and
- a projection system configured to project the patterned radiation beam onto the substrate, wherein the illumination system comprises a system according to the invention.

According to a further embodiment of the invention, there is provided a lithographic apparatus to project a pattern from a patterning device onto a substrate, comprising a programmable illuminator according to the invention for conditioning a radiation beam used to illuminate the patterning device and/or for conditioning a radiation beam used to measure a target structure on the substrate.

According to yet another embodiment of the invention, there is provided an inspection and/or metrology apparatus for conditioning a radiation beam used to measure a target structure on a substrate.

According to yet a further embodiment of the invention, there is provided a method to determine an incident light related energy parameter of a micromirror array, the micromirror array comprising at least some micromirrors for reflecting incident light each of the at least some micromirrors comprising a temperature sensor configured to measure a temperature of the respective micromirror, wherein the method comprises using the measured temperatures to determine an incident light related energy parameter.

According to another embodiment of the invention, there is provided a device manufacturing method wherein use is made of a lithographic apparatus according to the invention.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically depicts a part of a micromirror array according to an embodiment of the invention comprising a micromirror and four piezoelectric actuator devices;
- Figure 3 schematically depicts a cross-section of a part of a micromirror array according to another embodiment of the invention;
- Figure 4 schematically depicts a part of a micromirror array according to a further embodiment of the invention having multiple different displacement sensors for measuring micromirror displacement;
- Figure 5 schematically depicts a part of a piezoresistor sensing element for use in one of the embodiments of Figures 2 to 4;
- Figure 6 schematically depicts the construction of the piezoresistor sensing element and a temperature sensor in the arrangement of figure 5;
- Figure 7a schematically depicts a configuration of resistors in an electrical bridge element used to convert a sensor signal generated by the piezoresistor sensing element in the arrangement of Figure 5;
- Figure 7b schematically depicts a sensing beam in one of the embodiments of Figures 2 to 5, and a control unit receiving, converting and transmitting electronic signals generated in the sensing beam;
- Figure 7c schematically depicts a control system in one of the embodiments of Figures 2 to 5; and
- Figure 7d schematically depicts a portion of the control system of Figure 7c which is associated with a micromirror element.

### DETAILED DESCRIPTION

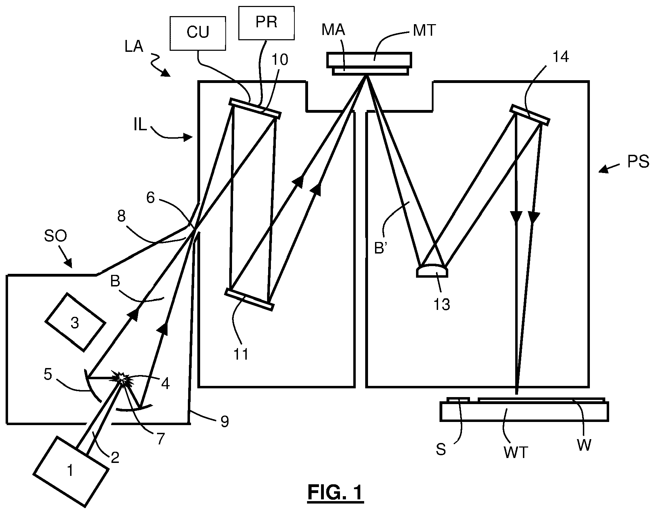

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The radiation source SO shown in Fig. 1 is of the laser produced plasma (LPP) type. A laser 1, which may for example be a CO₂ laser, is arranged to deposit energy via a laser beam 2 into a fuel, such as a tin (Sn) which is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure which is arranged to reflect EUV radiation (e.g. EUV radiation having a desired wavelength such as 13.5 nm). The collector 5 may have an ellipsoidal configuration, having two ellipse focal points. A first focal point may be at the plasma formation region 4, and a second focal point may be at an intermediate focus 6, as discussed below.

The laser 1 may be remote from the radiation source SO. Where this is the case, the laser beam 2 may be passed from the laser 1 to the radiation source SO with the aid of a beam delivery system (not shown) comprising, for example, suitable directing mirrors and/or a beam expander, and/or other optics. The laser 1 and the radiation source SO may together be considered to be a radiation source.

The radiation beam B passes from the radiation source SO into the illumination system IL including the field mirror device 10 and the pupil mirror device 11, which illumination system IL configured to condition the radiation beam. The field mirror device 10 and/or the pupil mirror device 11 comprise a micromirror array made up of individually controllable micromirrors. A micromirror of the array with associated components of an actuator system and a measurement system may be referred to as a micromirror assembly. A control unit CU, shown only in relation to the field mirror device 10, controls the orientations of the micromirrors (as is described further below). In that case the illumination system IL may be a programmable illuminator IL.

The radiation source AO shown in Fig. 1 may include components which are not illustrated. For example, a spectral filter may be provided in the radiation source SO. The spectral filter may be substantially transmissive for EUV radiation but substantially blocking for other wavelengths of radiation such as infrared radiation.

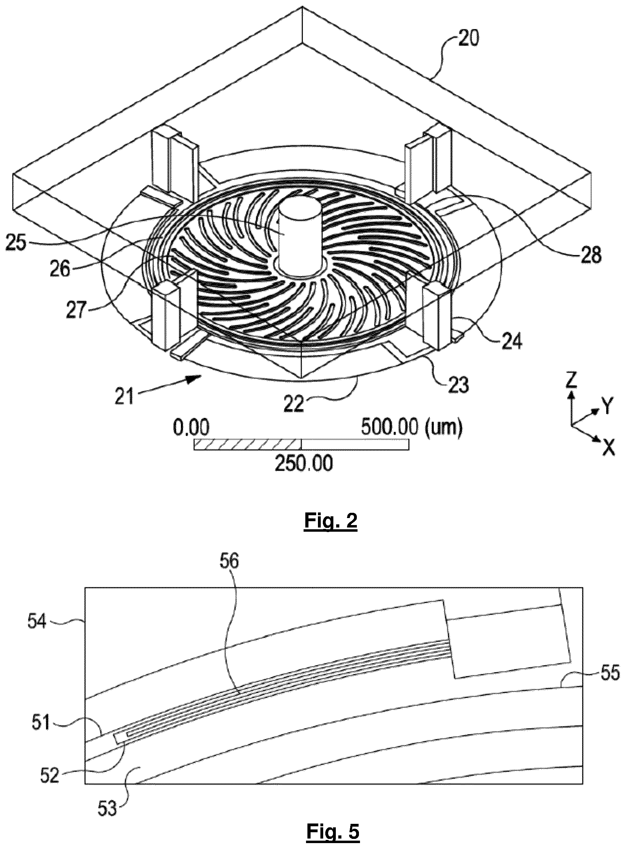

Figure 2 shows a system, in particular a MEMS system, with a micromirror 20 which is part of a micromirror array. The MEMS system has a four-fold rotational symmetry about an axis. The MEMS system comprises an actuator system including in this embodiment four piezoelectric actuators 21 as actuator devices arranged symmetrically under the micromirror 20 to enable tip and tilt displacement of the micromirror 20. The micromirror 20 is typically rectangular (which in this document is used to include square) with each side being in the range 0.5mm to 2.5mm. For example, it may be square with a 1 mm² surface area. In other embodiments the micromirror may be another shape, such as hexagonal. Each piezoelectric actuator 21 has a curved strip of flexible material 22, fixed to the underlying substrate (not shown) at one end and connected via a hinge 23 to a pillar 24. The strip of flexible material 22 has an elongation direction which at rest lies substantially parallel to the plane of the front surface of the micromirror 20. The strip of flexible material 22 has a layer of piezoelectric material (e.g. PZT) on it, to which a voltage can be applied in order to activate the piezoelectric actuator 21. When activating the piezoelectric actuator 21, the strip 22 bends, acting as a cantilever, to displace the micromirror 20 via the pillar 24. The magnitude of the displacement is a function of the applied voltage (as well as being a function of other parameters, such as the geometry of the piezoelectric actuator). The hinge 23 is formed by narrowing the strip 22 at one end, so that the cross sectional area of the hinge 23 is smaller than that of the strip 22 along the elongation direction of the strip 22. The hinge 23 is therefore less stiff than the strip 22, which allows it to act as a hinge. The hinge is typically required to flex in a plane transverse to an axis direction, which itself is transverse to the elongation direction of the strip 22.

The micromirror 20 is also connected to a heat diffuser, comprising a thermally conductive post 25 connected to the center of the back of the micromirror 20, and a heat sink 26 connected to the other end of the post 25. In a rest condition, the length direction of the post 25 is the axis of four-fold rotational symmetry of the MEMS system. The thermally conductive post 25 is arranged to transfer heat from the micromirror 20 to the heat sink 26, which diffuses the heat over a relatively large surface area. The heat sink 26 comprises a flexible membrane being a circular, patterned silicon layer. It may alternatively have multiple layers; if so, one or more (e.g. all) of the layers may be silicon, and one or more layers may be of material of other than silicon. The flexible membrane has curved grooves 27 formed in it, which increase the flexibility of the flexible membrane. In use, when the micromirror 20 is displaced, the thermally conductive post 25 pivots and elastically deforms the flexible membrane.

The MEMS system further includes a measurement system with a plurality of displacement sensors 28, such that each piezoelectric actuator 21 is associated with a respective displacement sensor 28, being a piezoresistor fixed to the pillar 24 at one end and to the underlying substrate at the other. As the pillar 24 is displaced, the piezoresistor is stressed/deformed, which changes the electric properties of the piezoresistor, from which the displacement can be determined. For example, the piezoresistor may be connected in a Wheatstone bridge, configured so that the output voltage of the bridge is a function of the displacement of the micromirror 20. The output from the piezoresistor may be temperature sensitive, and temperature compensation may be used to increase the accuracy of displacement measurements.

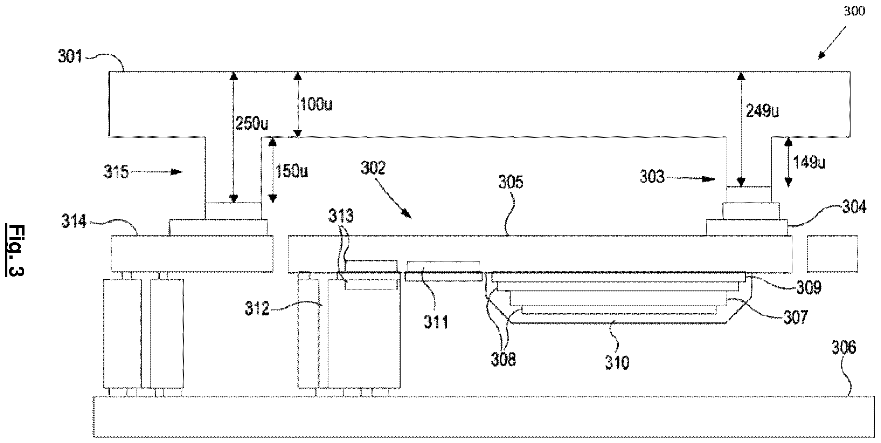

Figure 3 shows a schematic diagram of a cross section of a part of a micromirror array 300 according to an embodiment. A micromirror 301 is connected to a piezoelectric actuator 302 via a pillar 303. The pillar 303 comprises layers of silicon, germanium, aluminum and oxide having a combined thickness of for instance 151 µm. The oxide layer 304 may have a thickness of 1 µm and provides both thermal and electrical insulation to protect the piezoelectric actuator 302.

The piezoelectric actuator 302 comprises a strip of flexible material 305, being a strip of silicon of e.g. 5 µm thick, connected to a substrate 306 at the opposite end from the pillar 303. The piezoelectric actuator 302 also comprises a layer of piezoelectric material 307 being a layer of PZT having a thickness in the range of 500 nm to 2 µm. The layer of piezoelectric material 307 has top and bottom electrodes 308 made of platinum (Pt) and LaNiO3 (LNO) for applying a voltage to the layer of piezoelectric material 307. The layer of piezoelectric material is bonded to the strip of flexible material 305 by a layer of nitride (SiN) 309 having a thickness of e.g. 100 nm. The stack of SiN/Pt/LNO/PZT/Pt/LNO is covered by a layer of silicon oxide and aluminum oxide 310. Applying a voltage to the electrodes 308 causes the layer of piezoelectric material 307 to contract or expand, but because the layer is constrained at the interface to the strip of flexible material 305, the combined system of the layer of piezoelectric material 307 and the strip of flexible material 305 bends. It is this bending motion of the piezoelectric actuator 302 which displaces the pillar 303 and thereby also the micromirror 301.

A displacement sensor 311 comprising a piezoresistor is embedded in the strip of flexible material 305 and covered by oxide. The displacement sensor 311 is arranged to sense the deflection of the piezoelectric actuator 302.

The piezoelectric actuator 302 is electrically connected to the substrate 306 by a through silicon via (TSV) 312. Application specific integrated circuits (ASICs) 313 can be used to apply the voltage to the piezoelectric actuator 302 and also to derive the output voltage from the displacement sensor 311.

The micromirror 301 is connected to a heat sink 314 by a thermally conductive post 315. The heat sink 314 and the thermally conductive post 315 together form a heat diffuser for dissipating heat from the micromirror 301. The post 315 comprises layers of silicon, germanium and aluminum. The heat sink 314 comprises a flexible element, specifically in this example a flexible membrane of silicon, which allows the post 315 to move as the micromirror 301 is displaced. The heat sink 314 is electrically connected to the substrate 306, and may be grounded to prevent charge build up on the micromirror 301. The heat sink 314 and the strip of flexible material 305 are in the same plane and may be formed from the same silicon wafer. The spacing between the lower surface of the micromirror 301 and the upper surface of the heat sink 314 and/or the strip of flexible material 305 may be in the range 50µm-120µm, such as about 80µm. Typically, known micromirror arrays have a smaller spacing than this, such as only a few microns. The greater spacing is achieved in this embodiment because the (piezoelectric) actuation force is generated on the strip of flexible material 305, rather than, for example, by an electrostatic actuator mounted on the micromirror itself, which would typically limit the range of movement of the micromirror to the range of relative movement of components of the electrostatic actuator.

The spacing between the lower surface of the heat sink 314 and/or the strip of flexible material 305, and the upper surface of the substrate may be in the range 50µm-120µm, such as about 80µm.

Each micromirror may be provided with one or more control devices which are operative to recognize, in a received control signal, an address corresponding to the micromirror, and, upon recognizing the address, to generate control voltages for one or more piezoelectric actuators of the micromirror based on control information additionally contained in the control signal. The control devices may be implemented as the ASICs 313 which receive the control signals using the vias 312 and control the corresponding piezoelectric actuator 302 based on it; in this case, the address in the control signal may specify not only the micromirror but also the ASIC 313 for a given piezoelectric actuator 302. Using the control devices, an external control unit is able to individually control all the micromirrors of the micromirror array, by transmitting identical control signals to the control devices of all of the micromirrors, such that each control device recognizes control signals addressed to it, and controls the corresponding piezoelectric actuator(s) accordingly. Positioning the ASICs 313 within the structure, e.g. supported above the substrate 306 and proximate to (e.g. substantially in plane with) the strip of flexible material 305, is achievable because the embodiment may be formed in multiple layers by a MEMS process.

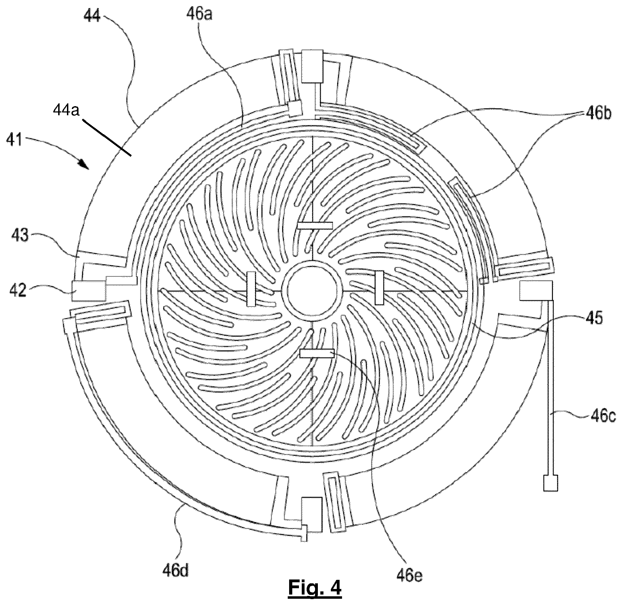

Figure 4 shows a schematic diagram of a top view of a MEMS system 41 for controlling a micromirror (not shown) in a micromirror array according to an embodiment. The system 41 comprises four piezoelectric actuators 44 connected to the micromirror by respective pillars 42. Reference numerals have only been indicated in relation to one of the four piezoelectric actuators 44. Each piezoelectric actuator 44 comprises a strip of flexible material 44a and a hinge 43, wherein the pillar 42 is connected to the hinge 43 at one end of the strip 44a and wherein the other end of the strip 44a is connected to (that is, in a substantially fixed positional relationship to) the substrate (not shown). The system 41 also comprises a heat diffuser 45 for diffusing heat from the micromirror when in use. The heat diffuser 45 comprises a circular silicon layer fixed to the substrate along an outer edge of the silicon layer and a thermally conductive post connected to the center of the silicon layer.

The system 41 comprises any one or more of five different types of displacement sensors 46a to 46e illustrated in Figure 4 for sensing a displacement of the micromirror. Each displacement sensor 46a to 46e comprises a piezoresistor arranged so that displacement of the micromirror induces stress in the piezoresistor. Preferably, each of the actuators is provided with only one of these five types of displacement sensor 46a to 46e, and the same type of displacement sensor is used in each of the four actuators 44.

A first type of displacement sensor 46a comprises a curved beam located in the annular space between the heat diffuser 45 and the piezoelectric actuator 44 and fixed to the substrate at one end and to the pillar 42 at the opposite end. One or more piezoresistors may be formed in the beam.

A second type of displacement sensor 46b comprises two folded beams comprising respective piezoresistors, each located in the annular space between the heat diffuser 45 and the piezoelectric actuator 44. One of the folded beams is connected to the substrate and to the pillar 42, whereas the other folded beam is connected to two different points of the substrate to provide a reference value.

A third type of displacement sensor 46c comprises a straight beam comprising a piezoresistor connected to the pillar 42 at one end and to the substrate at the other end.

A fourth type of displacement sensor 46d comprises a curved beam comprising a piezoresistor, the beam being located outside the piezoelectric actuator 44. The beam is connected to the substrate at one end and to the pillar 42 at the opposite end.

A fifth type of displacement sensor 46e comprises four piezoresistors fixed to the heat diffuser 45. The fifth displacement sensor 46e is for sensing deformation of the heat diffuser caused by displacement of the micromirror.

Figure 5 shows a schematic diagram of a top view of a part of a displacement sensor 50, which may be the first displacement sensor 46a in Figure 4 but the other displacement sensors have a similar construction. The displacement sensor 50 comprises a curved beam 51 (also referred to here as a sensing beam) and a folded piezoresistor 52 (piezoresistor sensing element) in the annular space 53 between the piezoelectric actuator 54 and the heat diffuser 55. One end of the beam 51 may be anchored to the substrate, and the beam 51 may be deformed by motion of the micromirror, thus changing the resistance of the piezoresistor 52. A temperature sensor 56 may be provided to measure the temperature of the piezoresistor 52. The temperature sensor 56 may for example be implemented as a bipolar transistor or a diode, since for such devices the current is a function of temperature. The sensors 52, 56 are preferably placed as close as possible to the anchor point of the beam 51 to limit the temperature swing during measurement. The sensing beam 51 acts as a thermal resistor between the high temperature of the micromirror and the low temperature anchor.

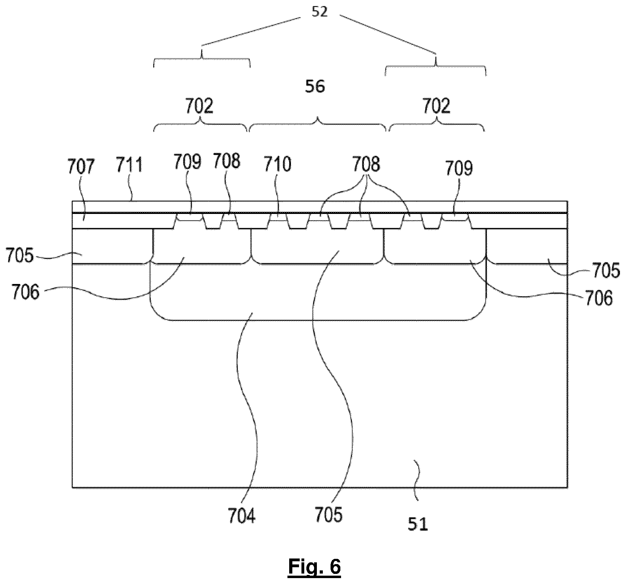

Figure 6 shows an example of the construction of a piezoresistor sensing element 52 and temperature sensor 56 in the curved beam 51. In Figure 6, the curved beam 51 is shown in cross-section looking along its length direction, and all regions shown extend in the length direction, i.e. in the direction into the page.

The folded piezoresistor 52 is implemented as two "legs" 702 which lie to either side of the temperature sensor 56.

The curved beam 51 may be formed of p-type silicon or other semiconductor. It includes a buried deep well of n-type semiconductor 704. In a region above the n-well well 704, are wells of p-type semiconductor 705 and wells of n-type semiconductor 706. All the wells 704, 705, 706 may be formed by ion implantation into the curved beam 51. The layer above the wells 704, 705, 706 is labelled 707. It is an insulating layer, such as of SiO₂. Implants 709 of piezoelectric material, and n-plus doped regions 708, are formed in wells in regions left open by gaps in the insulating layer 707, which isolates the different implant regions electrically from each other. Thus, each of the legs 702 is constituted by one of the piezoelectric implants 709 and, spaced from it in the direction towards the other of the legs 702, one of the n-plus doped regions 708. The legs 702 and temperature sensor 56 are covered by a further insulating layer 711 as a cover layer.

The temperature sensor 56, which is between the legs 702, is implemented by p-plus doped semiconductor region 710 and two n-plus doped regions 708. These regions collectively form a bipolar transistor. The bipolar transistor is connected as a diode by electrically connecting the base and collector together at a position outside the plane of Figure 6. Due to the close proximity of the sensors 52, 56, the temperature difference between them is very small.

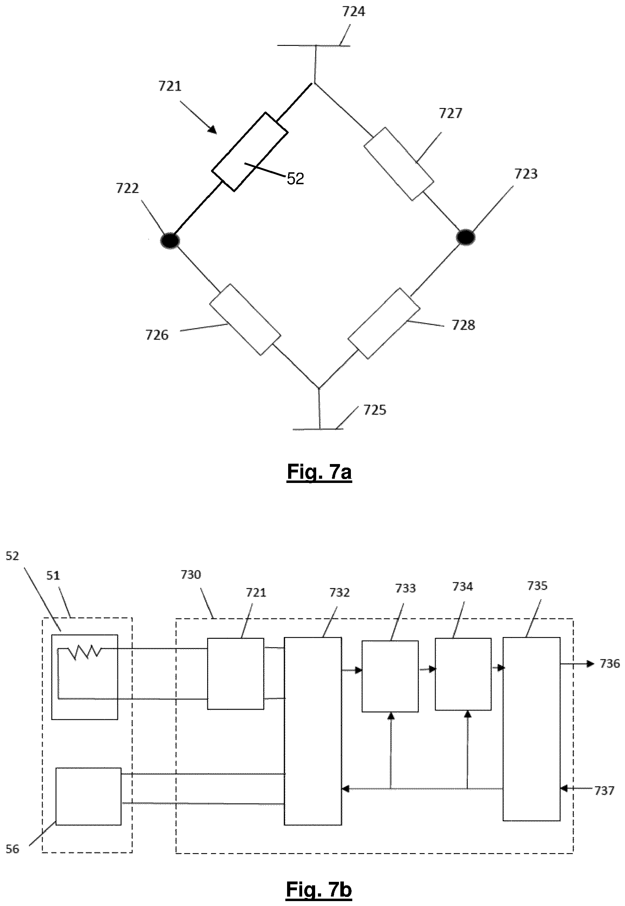

Figure 7a shows a circuit diagram of an electronic bridge element 721 (Wheatstone bridge). The bridge element 721 includes a first output terminal 722, and a second output terminal 723, and two voltage supply terminals 724, 725. The two voltage supply terminals 724 and 725 are connected to different respective steady voltages. For example the voltage supply terminal 724 may be connected to a positive supply voltage Vₛ and the voltage supply terminal 725 may be connected to ground.

The piezoresistor 52 is connected between the voltage supply terminal 724 and the first output terminal 722. A change in the resistance of the piezoresistor 52, results in a change of the voltage between first and second output terminals 722 and 723. Thus, the bridge element 721 may receive as input a voltage difference between the supply terminals 724 and 725 and may generate a voltage (signal) difference between the first and second output terminals 722 and 723 as an analogue sensor signal, which analogue sensor signal is dependent on the resistance of the piezoresistor 52, which is representative for the stress in the piezoresistor 52, which in turn is representative for the displacement of the micromirror.

Figure 7b shows schematically the analogue temperature signals passing from the sensing beam 51 to a control unit 730. This control unit 730 may correspond to one of the ASICs 313 shown in Fig. 3. The control unit 730 receives the analogue temperature signal generated by the temperature sensor 56, and the analogue sensor signal generated by the piezoresistor sensing element 52. The sensor signal generated by the piezoresistor sensing element 52 is converted by the electronic bridge element 721. The outputs of the electronic bridge element 721 and the temperature sensor 56 are transmitted to a multiplex unit 732 of the control unit 730.

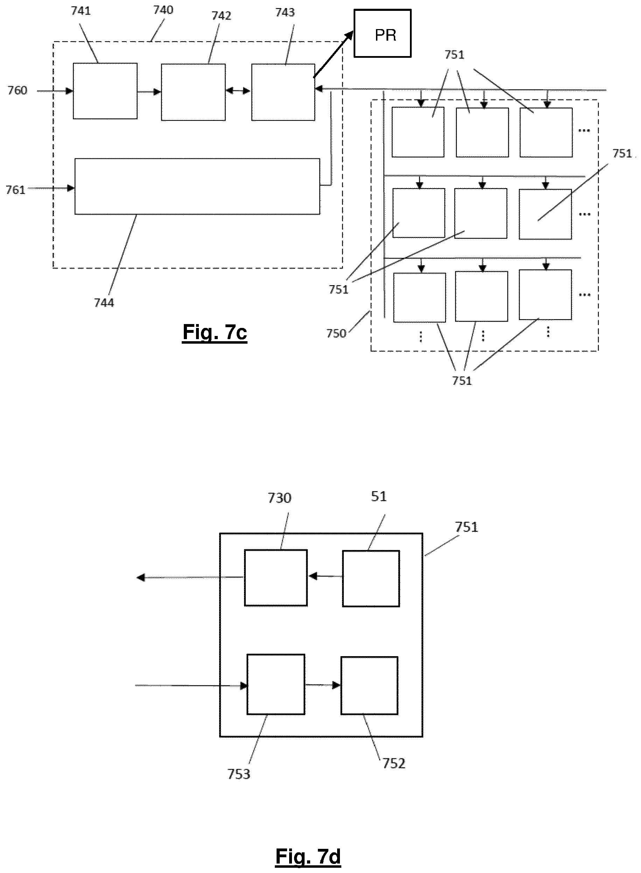

The control unit 730 also includes an electronic interface 735 which is in two-way communication with a controller (shown as 740 in Figure 7c, described below). The controller may be mounted on the substrate, for example in the position on the underside of the substrate 306 in the arrangement shown in Fig. 3. The control unit 730 and controller may in this case communicate using vias passing through the substrate 306, which are electrically connected to the vias 312. The signals transmitted by the control unit 730 to the controller are labelled 736 in Figure 7b, and the signals received from the controller are labelled 737.

The components of the control unit 730 shown in Figure 7b are those which generate the signal 736, but there may be other components of the control unit 730 which receive command signals (included in signal 737) which instruct the control unit 730 to transmit the actuator control voltages to the piezoelectric actuator(s) of the micromirror. Alternatively, these other components may be part of a different control unit (e.g. in the case of Fig. 3 another of the ASICS 313). This second possibility is assumed in Figure 7d, described below.

The signals 737 which the control unit 730 receives from the controller using the interface 735 may include a clock signal which the interface 735 transmits to the multiplex unit 732. Based on this clock signal, the multiplex unit 732 transmits to an amplifier unit 733 selectively at different times both: the converted sensor signal generated by the electronic bridge element 721; and the temperature signal output by the temperature sensor 56.

The amplifier unit 733 amplifies the signal it receives and transmits it to an analogue-to-digital converter (ADC) 734. The number of bits in the digitized signals produced by the ADC depends upon the required accuracy in the control of the micromirrors, and is typically at least 9 bits. In one example, the ADC may provide a resolution of 14 bits. Both the amplifier unit 733 and the ADC 734 may also receive the clock signal.

At times when the ADC 734 receives from the amplifier unit 733 the analogue sensor signal generated by the electronic bridge element 721, the ADC 734 generates a digital sensor signal. At times when the ADC 734 receives from the amplifier unit 733 the analogue temperature signal generated by the temperature sensor 56, the ADC 734 generates a digital temperature signal.

In either case, the output of the ADC 734 is transmitted by the interface 735 to the controller as the signal 736.

Optionally, the electric bridge unit 721 of the control unit 730 may further include a bridge temperature sensor which generates at least one analogue bridge temperature signal. The bridge temperature signal indicates the temperature of the resistors 726, 727, 728 of the electronic bridge unit 721. The bridge temperature signal is transmitted to the multiplex unit 732. With a timing depending upon the clock signal, the multiplex unit 732 transmits the bridge temperature signal to the amplifier unit 733, which in turn transmits it to the ADC 734. The ADC 734 uses the amplified bridge temperature signal to generate a digital bridge temperature signal. This too is transmitted to the interface 735, and transmitted to the controller as part of the signal 736.

Turning to Figure 7c, the overall control system is shown. The portion of the control system which is associated with each of the micromirror elements is indicated as 751, and is shown in more detail in Fig. 7d. Each circuitry portion 751 includes the circuitry shown in Figs. 5-6 and 7a provided on the sensing beam 51, and the control unit 730 depicted in Figure 7b. It also includes a second control unit 753 (e.g. another ASIC 313) associated with the micromirror, which receives control signals generated by the controller 740 which encode target actuator control voltages calculated by the controller 740 as discussed below. Based on these target actuator control voltages, the second control unit 753 generates actuator control signals having voltages equal to the target actuator control voltages, and transmits the actuator control signals to the piezoelectric actuator(s) 752 associated with the corresponding micromirror, to cause the actuators to move the mirror.

Thus, the control system includes an array 750 of circuitry portions 751 associated with the respective micromirrors, and each of the circuitry portions 751 is in two-way communication with the controller 740 as shown in Figure 7c, using an interface 743 of the controller 740. The interface 743 allows each circuitry portion 751 to transmit the digital sensor signal and corresponding digital temperature signals for each of the piezoresistor sensing elements, via an internal bus of the controller 740, to a mirror control unit 742. In the case that the electric bridge units 721 include a bridge temperature sensor which generates a bridge temperature signal, the digital bridge temperature signal generated by the ADC 734 of the control unit 730 is also passed to the mirror control unit 742.

The controller 740 includes a power management and reference generation unit 744 which receives an external power signal 761 from a power source outside the micromirror array. The power management and reference generation unit 744 powers the rest of the controller 740, and supplies power to the array 750 of circuitry portions 751. The controller 740 also includes an interface 741 for receiving a control signal 760 from outside the micromirror array, and transmitting it to the mirror control unit 742. Thus, the mirror control unit receives: the received control signal 760, the digital sensor signals and digital temperature signals. In the case that the electronic bridge unit 721 generates a bridge temperature signal, the mirror control unit 742 receives the digital bridge temperature signal also. Using all these signals, the mirror control unit calculates target actuator control voltages for all the actuators of all the micromirrors as discussed below. These are transmitted by the interface 743 to the second control units 753 of all the circuitry portions 751, and used by the second control units 753 to generate the actuator control signals. The second control units 753 transmit the actuator control signals to the actuator(s) 752 of the corresponding mirrors.

The mirror control unit 742 calculates target actuator control signals which are intended to implement instructions for positioning the micromirrors which are encoded in the control signal 760. The best target actuator control signals to achieve this depend upon the digital sensor signal, the digital temperature signal and the digital bridge temperature signal (if any). The relationship between the target actuator control signals and the signals the mirror control unit 742 calculates them from is a predetermined function. It may be obtained experimentally. Because the calculation of the target actuator control voltages is carried out on digital signals, the calculation of the actuator control signals is much more straightforward than attempting to do this using analogue signals would be. Furthermore, a more sophisticated calculation can be performed, in which for example the dependence of the target actuator control signals on the digital temperature signal includes not only a linear (1^{st} order) dependence on the digital temperature signal but preferably also a 2^{nd} and/or 3^{rd} order dependence on the digital temperature signal. It has been found that the accuracy of determining the flexing of the micromirror in the present arrangement is better than 40 parts per million (ppm).

The calculation may include modeling the strain in the temperature sensor. With this model, the temperature value indicated by the digital temperature signal is corrected to compensate for strain in the temperature sensor, which influences the output of the temperature sensor. The correction is performed using the digital sensor signal, and may include 1^{st}, 2^{nd} and/or 3^{rd} order dependency on the digital sensor signal (and optionally on the digital bridge temperature signal (if any) also).

Similarly, the calculation may include modeling an estimated temperature value representing the temperature in the piezoresistor sensing element. In this model the strain value indicated by the digital sensor signal is corrected to compensate for the temperature in the piezoresistor sensing element, which influences the digital sensor signal. The correction is performed using the digital temperature signal, and may include 1st, 2nd and/or 3rd order dependency on the digital temperature signal (and optionally on the digital bridge temperature signal (if any) also).

Embodiments of the micromirror array can provide tip and tilt displacement range of +/-120 mrad and an accuracy down to about 25 µrad. Embodiments of the micromirror array can be operated at high light intensities as required for EUV, and may work at 40 to 60 kW/m² of absorbed thermal power density (which implies an incident light power density on the surface of the mirror which is even larger). This is orders of magnitude higher than the absorbed thermal power density of micromirror arrays used in some other applications. This is possible because the piezoelectric actuators 41 are operative to provide, even at a relatively low actuator voltage (e.g. under about 100V), such a strong force that they are able to deform the flexible element (flexible member 314) even though the flexible element is thick enough to provide high heat conductivity to the substrate. Due to the high thermal conductivity, the micromirror array may in use have a temperature of under about 100 degrees Celsius.

The temperature signals from the temperature sensors 56 are further transmitted to a processor PR, visible in Fig. 1 and Fig. 7c. In this example, the interface 743 is used to transmit the temperature signals received from the micromirror elements 751 to the processor PR, but it will be apparent that the temperature signals, whether analogue or digital can be obtained and transmitted to the processor PR at any location in the system, control unit or controller where these temperature signals are available.

The processor PR is configured to receive the temperature signals of at least some of the micromirror elements and to determine an incident light related energy parameter. Although the processor PR is depicted as a separate entity from the controller CT, the processor PR may form part of the controller.

In the above described examples and embodiments, the actuator system comprises actuator devices based on the piezoelectric effect and the measurement system comprises displacement sensors based on the piezoresistive effect, both effects being highly sensitive to temperature changes. Hence, the temperature sensors are used to interpret the sensor signals from the displacement sensors to determine the actual displacement of a corresponding micromirror and to calculate the correct actuator control signal allowing the actuator device to position the corresponding micromirror in the desired position. In other words, the control unit is configured to generate the one or more actuator control signals based on an output of the measurement system and based on an output of the temperature sensors. However, when the actuator system and/or the measurement system and/or the required position accuracy is less dependent on temperature, for instance when the actuator system comprises electrostatic actuators and the measurement system comprises capacitive sensors, a dedicated temperature sensor per actuator device or per displacement sensor may not be needed for correctly interpreting the sensor signals and/or calculating the actuator control signals. However, a temperature sensor is then still provided for at least some of the micromirrors to allow the processor PR to determine the incident light related energy parameter. In that case, the temperature signals do not necessarily have to be provided to the mirror control unit 742.

Further, in the above examples and embodiments, each micromirror element comprises a plurality of sets, each set comprising an actuator device, e.g. a piezoelectric actuator, a displacement sensor and a temperature sensor with the actuator device being part of the actuator system and the displacement sensor being part of the measurement system. In such a case, the control unit is preferably configured to generate the actuator control signal for the actuator device of a set based on an output of the corresponding displacement sensor and corresponding temperature sensor. In embodiments where the temperature variation between different sets is relatively small, a dedicated temperature sensor per set may not be needed and less temperature sensors then sets may be used for generating the actuator control signals.

In the case where two or more temperature signals are available per micromirror element due to a plurality of temperature sensors being provided per micromirror, only one temperature signal from one temperature sensor may be used by the processor PR to determine the incident light related energy parameter. Alternatively, the processor PR may use an output of two or more temperature sensors of a micromirror element to determine a temperature representative for the temperature of the micromirror, e.g. by calculating an average temperature based on the output of the two or more temperature sensors or a weighted average temperature. The presence of two or more temperature sensors per micromirror may also be used to provide redundancy allowing to provide temperature signals even if one of the temperature sensors ceases to operate.

In an embodiment, the processor PR is configured to receive the measured temperatures when radiation from a specific radiation source, e.g. the EUV radiation source SO in Fig. 1, is incident upon the micromirror array, and wherein the processor PR is further configured to compare the measured temperatures of the micromirrors with temperatures previously measured when no radiation from the specific radiation source SO is incident upon the micromirror array to provide temperature change measurements. Hence, in an embodiment, the temperature of a micromirror may be measured when no radiation, e.g. EUV radiation, is incident upon the micromirror and then subsequently measured when radiation, e.g. EUV radiation is incident upon the micromirror. The change may then be determined. The change of temperature is directly determined by the power of EUV radiation incident upon the micromirror. In this case, the light incident related energy parameter to be determined by the processor PR may be a power of radiation incident upon the micromirrors. In an embodiment of the invention around 200 W of EUV radiation may be incident upon the micromirror array, and around 80 W may be absorbed by the micromirror array. As a result, a significant heating of the micromirrors occurs, resulting in a temperature increase of the micromirrors. This allows the incident EUV radiation power to be determined with reasonable accuracy.

Temperature measurements are preferably performed for a plurality of micromirrors of the micromirror array. This in turn allows EUV radiation power measurements to be determined for a plurality of positions across the mirror array. This is advantageous compared with a single EUV radiation power measurement because it distinguishes between a generalized change of the power of EUV radiation and spatially localized changes of the power of EUV radiation.

The processor PR may be configured to compare temperature change measurements with previously obtained temperature change measurements. If the power of EUV radiation on substantially all of the micromirrors has reduced compared to previously temperature change measurements, as indicated by a smaller temperature changes, then a general reduction of the output power of the EUV radiation source has occurred. If the EUV radiation power at most of the micromirrors has remained substantially the same (the temperature change is substantially the same) but there has been a change of EUV radiation power at a sub-set of micromirrors (the temperature changes of those micromirrors has changed significantly) then this indicates a spatially localized problem. The spatially localized problem may for example be localized contaminants on the collector. Similarly, if a reduction of EUV power is seen for substantially all of the micromirrors (i.e. the temperature change for those micromirrors) but some of the micromirrors see a significantly larger drop of EUV radiation power (i.e. a smaller temperature change) then this may indicate that the power of the EUV radiation source has dropped generally but in addition there is a spatially localized problem such as contamination on the collector.

In an embodiment, the incident light related energy parameter is determined using a known relationship between the incident light related energy parameter and the measured temperatures. The known relationship may be expressed as a model which takes into account the absorption of radiation by micromirrors of the micromirror array. The model may also take into account the spectrum of radiation emitted by the plasma and/or thermal properties of components of the micromirror elements. Alternatively, or additionally, the known relationship comprises stored data indicating temperature changes for a plurality of different incident radiation intensities.

Micromirrors of the micromirror array will have an equilibrium position in which the micromirrors are all in the same plane with a normal to the micromirrors being parallel to an optical axis of the micromirror array. Temperature change measurements may be carried out when the micromirrors are in their equilibrium position or when the micromirror is tilted away from its equilibrium position. However, when a micromirror is tilted away from its equilibrium position the angle of incidence of the EUV radiation upon that micromirror is changed and this in turn affects the proportion of EUV radiation which is reflected by the micromirror and the proportion which is absorbed. This may be because the micromirror comprises a series of layers with thicknesses selected to provide constructive interference of EUV radiation reflected from layer boundaries, and tilting the micromirror will have the effect of presenting layers of increased thickness to the EUV radiation. Since the reflectivity and absorbance of the micromirror is modified when it is tilted, the accuracy of the incident light related energy parameter obtained using the tilted micromirror will be reduced accordingly. The accuracy of the measurement may be improved by performing a calibration of the effect of the tilt and then taking that calibration into account when performing subsequent measurements. An advantage which arises from performing measurements when the micromirrors are not in their equilibrium positions is that this allows the determination of the light incident related energy parameter to occur during production exposure of substrates. This is advantageous because it avoids lost productivity which would occur if substrate production was stopped in order to determine the light incident related energy parameter.

As mentioned above, the incident light related energy parameter may be a power of radiation incident upon the micromirrors. Alternatively, or additionally, the incident light related energy parameter may include a power of radiation reflected by the micromirrors, and/or a power of radiation absorbed by the micromirrors, and/or a power distribution across the micromirror array.

Determining the incident light related energy parameter of the micromirror array when the micromirror array is part of the field mirror device allows for instance adjustment of the power of EUV radiation output by the radiation source using feedback control. This allows the power of EUV radiation to be kept relatively high such that more substrates can be exposed per hour whilst ensuring that the power of EUV radiation is not so high that it will damage the lithographic apparatus.

The majority of EUV radiation is absorbed by components of the lithographic apparatus before it reaches the substrate W. This affects operation of the lithographic apparatus, and corrections may be applied accordingly. For example, EUV radiation may be absorbed by components of the projection system PS, an effect known as lens or mirror heating. This may introduce distortion into projected patterns. Components of the projection system may be adjusted to reduce such distortion. Embodiments of the invention allow the power of EUV radiation to be measured upstream of most components of the lithographic apparatus, and thus allow the amount of absorbed EUV radiation to be estimated more accurately. This in turn allows adjustments of the lithographic apparatus to be performed more accurately (e.g. lens or mirror heating corrections).

Using the micromirror array, the field mirror device or the pupil mirror device may include a relatively large number of micromirrors, e.g. more than 10,000 micromirrors, preferably more than 100,000 micromirrors. If a significantly larger number of micromirrors is used than the spatial resolution with which the light incident related energy parameter can be determined will be correspondingly increased.

Referring to Fig. 1, a sensor S provided on the substrate table WT may be used to measure the power of EUV radiation as reflected by particular micromirrors of the field mirror device 10. The sensor S may detect EUV radiation directly, or may include a layer of material which converts EUV radiation to a longer wavelength which is more easily detectable. Because the sensor S is located downstream of the illumination system IL, patterning device MA and projection system PS, these three elements will have an impact upon the power of EUV radiation seen at the sensor S. However, the impact of each of these elements may be known and/or separately measured and their effects removed from the measurement. Consequently, for given micromirrors two measurements can be obtained. The first measurement, obtained using an embodiment of the invention, is a measurement of the light incident related energy parameter, e.g. the power of EUV radiation incident upon, reflected or absorbed by the micromirror. The second measurement, obtained using the sensor S, is a measurement of the power of EUV radiation reflected by that micromirror onto the sensor. These two measurement allow a problem with the micromirror, such as for example degradation of the reflectivity of the micromirror, to be identified. In an example, a normalized incident light related energy parameter, e.g. radiation power, of value 100 at the micromirror may be expected to provide a radiation power of 1 at the sensor S. If a significantly lower radiation power is seen (e.g. 0.5), then this may be interpreted as meaning that the reflectivity of the micromirror has degraded (less radiation is being reflected by the micromirror and more radiation is being absorbed). Remedial action can then be taken to mitigate the impact of that micromirrors lowered reflectivity. For example, an illumination mode formed using the field mirror device 10 may be modified to reduce any impact of degraded micromirrors. During maintenance of the lithographic apparatus, if the number of degraded micromirrors is sufficiently high that it will affect operation of the lithographic apparatus then the field mirror device 10 may be replaced.

Damage of a micromirror may be identified by comparing the temperature change measurement seen for that micromirror with the temperature change measurement seen for adjacent micromirrors. For example, if the temperature change measurement of a micromirror is significantly higher than the temperature change measurement of immediately adjacent micromirrors then this may indicate that the reflectivity of that micromirror has reduced significantly (that micromirror is now absorbing more EUV radiation than adjacent micromirrors which are receiving approximately the same amount of EUV radiation). The micromirror may therefore be identified as damaged.

Although specific reference may be made in this description to embodiments of the invention in the context of lithographic apparatus, embodiments of the invention may be used in other apparatus. Embodiments of the invention may form part of a programmable illuminator for conditioning a radiation beam, a mask inspection apparatus, a metrology apparatus, or any apparatus that measures or processes an object such as a wafer (or other substrate) or mask (or other patterning device), e.g. an inspection and/or metrology apparatus including a programmable illuminator according to the invention for conditioning a radiation beam used to measure a target structure on a substrate. These apparatus may be generally referred to as lithographic tools. Such a lithographic tool may use vacuum conditions or ambient (non-vacuum) conditions.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm, such as 6.7 nm or 6.8 nm.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

The embodiments may further be described using the following clauses.
1. A system comprising:
   - a micromirror array comprising:
      ∘ a substrate,
      ∘ a plurality of moveable micromirrors for reflecting incident light and supported from the substrate,
      ∘ an actuator system configured to position each of the plurality of micromirrors based on one or more actuator control signals,
      ∘ a measurement system configured to measure a position of each of the plurality of micromirrors,
      ∘ a control unit configured to generate the one or more actuator control signals based on an output of the measurement system,
   - a processor,

   wherein at least some of the micromirrors of the array comprise a temperature sensor configured to measure a temperature of the respective micromirror,
   and wherein the processor is configured to receive the measured temperatures of the at least some micromirrors and to determine an incident light related energy parameter.
2. A system according to clause 1, wherein each of the plurality of micromirrors includes a temperature sensor.
3. A system according to clause 2, wherein the control unit is configured to generate the one or more actuator control signals based on an output of the measurement system and based on an output of the temperature sensors.
4. A system according to clause 2 or 3, wherein each micromirror includes a plurality of temperature sensors, and wherein the processor is configured to determine a temperature of the respective micromirror based on an output of two or more temperature sensors.
5. A system according to clause 4, wherein each micromirror includes at least two sets, each set comprising an actuator device, a displacement sensor and a temperature sensor, wherein the actuator device is part of the actuator system and the displacement sensor is part of the measurement system, wherein the actuator device is configured to displace the respective micromirror in a corresponding actuation direction based on a respective actuator control signal, wherein the displacement sensor is configured to measure a displacement of the respective micromirror in the corresponding actuation direction, and wherein the control unit is configured to generate the actuator control signal for the actuator device of a set based on an output of the corresponding displacement sensor and corresponding temperature sensor.
6. A system according to any of the preceding clauses, wherein the processor is configured to receive the measured temperatures when radiation from a specific radiation source is incident upon the micromirror array, and wherein the processor is further configured to compare the measured temperatures of the micromirrors with temperatures previously measured when no radiation from the specific radiation source is incident upon the micromirror array to provide temperature change measurements.
7. A system according to clause 6, wherein the processor is configured to compare temperature change measurements with previously obtained temperature change measurements.
8. A system according to any of the preceding clauses, wherein the incident light related energy parameter is determined using a known relationship between the incident light related energy parameter and the measured temperatures.
9. A system according to clause 8, wherein the known relationship is expressed as a model which takes into account the absorption of radiation by micromirrors of the micromirror array.
10. A system according to clause 8, wherein the known relationship comprises stored data indicating temperature changes for a plurality of different incident radiation intensities.
11. A system according to any of the preceding clauses, wherein the incident light related energy parameter is a power of radiation incident upon the micromirrors.
12. A system according to any of the preceding clauses, wherein the incident light related energy parameter is a power of radiation reflected by the micromirrors.
13. A system according to any of the preceding clauses, wherein the incident light related energy parameter is a power of radiation absorbed by the micromirrors.
14. A system according to any of the preceding clauses, wherein the incident light related energy parameter is a power distribution across the micromirror array.
15. A system according to any of the preceding clauses, wherein the incident light to be reflected by the micromirrors comprises EUV radiation.
16. A system according to clause 6, wherein the radiation source is an EUV radiation source.
17. A programmable illuminator comprising a system according to any of the preceding clauses for conditioning a radiation beam.
18. A programmable illuminator according to clause 17, further comprising a displacement control feedback system configured to determine for each micromirror of the plurality of micromirrors a position of the micromirror and to adjust an actuator control signal applied to the actuator system based on the determined position and based on a predefined target position of the micromirror.
19. A lithographic apparatus comprising:
   - an illumination system configured to condition a radiation beam,
   - a support structure constructed to support a patterning device, the patterning device being capable of imparting the radiation beam with a pattern in its cross-section to form a patterned radiation beam,
   - a substrate table constructed to hold a substrate, and
   - a projection system configured to project the patterned radiation beam onto the substrate,
   wherein the illumination system comprises a system according to any of clauses 1-16.
20. A lithographic apparatus according to clause 19, wherein the illumination system includes a field mirror device and a pupil mirror device to provide the radiation beam with a desired cross-sectional shape and a desired angular intensity distribution, and wherein the field mirror device comprises a system according to any of clauses 1-16.
21. A lithographic apparatus according to clause 19 or 20, wherein the illumination system includes a field mirror device and a pupil mirror device to provide the radiation beam with a desired cross-sectional shape and a desired angular intensity distribution, and wherein the pupil mirror device comprises a system according to any of clauses 1-16.
22. A lithographic apparatus arranged to project a pattern from a patterning device onto a substrate, comprising a programmable illuminator according to clauses 17 or 18 for conditioning a radiation beam used to illuminate the patterning device and/or for conditioning a radiation beam used to measure a target structure on the substrate.
23. An inspection and/or metrology apparatus, comprising a programmable illuminator according to clauses 17 or 18 for conditioning a radiation beam used to measure a target structure on a substrate.
24. A method to determine an incident light related energy parameter of a micromirror array, the micromirror array comprising at least some micromirrors for reflecting incident light each of the at least some micromirrors comprising a temperature sensor configured to measure a temperature of the respective micromirror, wherein the method comprises using the measured temperatures to determine an incident light related energy parameter.
25. A method according to clause 24, wherein the temperatures are measured when EUV radiation is not incident upon the micromirror array and are measured when EUV radiation is incident upon the micromirror array, and the measured temperatures are compared to provide temperature change measurements.
26. A device manufacturing method wherein use is made of a lithographic apparatus according to any of clauses 19-22.

## Claims

1. A system comprising:
- a micromirror array comprising:
∘ a substrate,
∘ a plurality of moveable micromirrors for reflecting incident light and supported from the substrate,
∘ an actuator system configured to position each of the plurality of micromirrors based on one or more actuator control signals,
∘ a measurement system configured to measure a position of each of the plurality of micromirrors,
∘ a control unit configured to generate the one or more actuator control signals based on an output of the measurement system,
- a processor,
wherein at least some of the micromirrors of the array comprise a temperature sensor configured to measure a temperature of the respective micromirror,
and wherein the processor is configured to receive the measured temperatures of the at least some micromirrors and to determine an incident light related energy parameter.

2. A system according to claim 1, wherein each of the plurality of micromirrors includes a temperature sensor.

3. A system according to claim 2, wherein the control unit is configured to generate the one or more actuator control signals based on an output of the measurement system and based on an output of the temperature sensors.

4. A system according to claim 2 or 3, wherein each micromirror includes a plurality of temperature sensors, and wherein the processor is configured to determine a temperature of the respective micromirror based on an output of two or more temperature sensors.

5. A system according to claim 4, wherein each micromirror includes at least two sets, each set comprising an actuator device, a displacement sensor and a temperature sensor, wherein the actuator device is part of the actuator system and the displacement sensor is part of the measurement system, wherein the actuator device is configured to displace the respective micromirror in a corresponding actuation direction based on a respective actuator control signal, wherein the displacement sensor is configured to measure a displacement of the respective micromirror in the corresponding actuation direction, and wherein the control unit is configured to generate the actuator control signal for the actuator device of a set based on an output of the corresponding displacement sensor and corresponding temperature sensor.

6. A system according to any of the preceding claims, wherein the processor is configured to receive the measured temperatures when radiation from a specific radiation source is incident upon the micromirror array, and wherein the processor is further configured to compare the measured temperatures of the micromirrors with temperatures previously measured when no radiation from the specific radiation source is incident upon the micromirror array to provide temperature change measurements.

7. A system according to claim 6, wherein the processor is configured to compare temperature change measurements with previously obtained temperature change measurements.

8. A system according to any of the preceding claims, wherein the incident light related energy parameter is determined using a known relationship between the incident light related energy parameter and the measured temperatures.

9. A system according to claim 8, wherein the known relationship is expressed as a model which takes into account the absorption of radiation by micromirrors of the micromirror array.

10. A system according to claim 8, wherein the known relationship comprises stored data indicating temperature changes for a plurality of different incident radiation intensities.

11. A system according to any of the preceding claims, wherein the incident light related energy parameter is a power of radiation incident upon the micromirrors.

12. A system according to any of the preceding claims, wherein the incident light related energy parameter is a power of radiation reflected by the micromirrors.

13. A system according to any of the preceding claims, wherein the incident light related energy parameter is a power of radiation absorbed by the micromirrors.

14. A system according to any of the preceding claims, wherein the incident light related energy parameter is a power distribution across the micromirror array.

15. A system according to any of the preceding claims, wherein the incident light to be reflected by the micromirrors comprises EUV radiation.
